(19)

Europäisches
Patentamt
European
Patent Office
Office européen
des brevets

(11)     **EP 4 134 683 A1**

(12)     **EUROPEAN PATENT APPLICATION**

(43) Date of publication:
**15.02.2023 Bulletin 2023/07**

(21) Application number: **21190312.5**

(22) Date of filing: **09.08.2021**

(51) International Patent Classification (IPC):
**G01R 25/04** (1968.09)     **G01R 25/00** (1968.09)
**G01R 22/06** (2006.01)

(52) Cooperative Patent Classification (CPC):
**G01R 25/04; G01R 22/068; G01R 25/00;**
G01R 22/066

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Itron Global SARL
Liberty Lake, WA 99019 (US)**

(72) Inventors:
• **TISSIER, Jean-Francois
CHASSENEUIL DU POITOU (FR)**

• **RAHMOUN, Abdellah Ben
MIGNALOUX BEAUVOIR (MA)**
• **CORNET, Jerome André Michel
BEAUMONT SAINT CYR (FR)**

(74) Representative: **Morrall, Jonathan Ian McLachlan
et al
Kilburn & Strode LLP
Lacon London
84 Theobalds Road
London WC1X 8NL (GB)**

(54)     **AUTOMATED ANALYSIS AND CORRECTION OF AN ELECTRICITY METER CONNECTION**

(57)     Apparatus and method provided herein are directed to an electricity meter for polyphase multiwire network, which determines a voltage vector sequence of a plurality of voltage vectors, a current vector sequence of a plurality of current vectors monitored at respective terminals of the electricity meter, phase differences between each of the voltage vectors, phase differences between each of the current vectors of the plurality of voltage vectors, and a quadrant location of each current vector. Based on the voltage vector sequence, the current vector sequence, the phase differences, and the quadrant locations, a virtual voltage distribution re-configuration and/or a virtual current distribution re-configuration are generated, and a revised power consumption based on the virtual voltage distribution re-configuration and/or the virtual current distribution re-configuration is calculated in an auxiliary register of the electricity meter while an active energy, measured as currently connected, is continues to be calculated in a main register.

FIG. 8

**Description**

**TECHNICAL FIELD**

The present disclosure relates to the field of electricity meters, and more specifically to analysis and correction of electricity meter connections.

**BACKGROUND**

An electricity meter (single or polyphase), measures power and energy correctly only if it is correctly wired. Incorrect wirings of the analog inputs (voltage and current) into the meter terminals may be a result of an unintentional human error or an intentional tampering. Therefore, a correct connection of the electricity meter on the grid needs to be verified periodically, and it is important for a distribution system operator (DSO) to be equipped with a tool to verify the correct connection of the electricity meter on the grid.

Electricity meters may be divided into two groups: Group 1 consisting of direct connected (DC) meters and Group 2 consisting of low voltage (LV) current transformer (CT) meters and CT voltage transformer (VT) meters. The DC meters are typically used as residential meters, and as the voltage and current are present on the same conductor, the only incorrect connections are an inversion of the phase and neutral wires (single phase meter) or permutations between phases (polyphase meter). For the LV CT and CT VT meters, as the voltage and current are separated, multiple connection errors may happen during the wiring of such meters, which introduce non-technical losses (NTLs) and result in lower or otherwise inaccurate calculated and registered energy.

**SUMMARY**

According to an aspect there is provided a method performed by an electricity meter as defined in claim 1. Optional features are defined in dependent claims 2 to 13. According to a second aspect there is provided an electricity meter as defined in claim 14. Optionally, the memory of the electricity meter comprises computer executable instructions that, when executed by the one or more processors, cause the one or more processors to perform operations comprising any of the method claims 2 to 13. According to a third aspect there is provided a computer-storage medium storing computer-readable instructions as defined in claim 15. Optionally, the computer-storage medium is non-transitory. Optionally, the computer-readable storage medium stores computer-readable instructions that, when executed by the one or more processors, cause the one or more processors to perform operations comprising any of the method claims 2 to 13.

**BRIEF DESCRIPTION OF THE DRAWINGS**

The detailed description is set forth with reference to the accompanying figures. In the figures, the left-most digit(s) of a reference number identifies the figure in which the reference number first appears. The use of the same reference numbers in different figures indicates similar or identical items or features.

FIG. 1 illustrates an example LV DC meter for low voltage networks.
FIG. 2 illustrates an example 3-phase CT VT meter for medium to high voltage networks.
FIG. 3 illustrates example analysis diagrams for a 3-phase, 4-wire network in which voltage and current vectors are represented in a complex plane.
FIG. 4 illustrates an example chart with measured values by a CT VT meter correctly connected in a 3-phase, 4-wire network and an Argand diagram representing the measured values.
FIG. 5 illustrates an example chart with measured values by a CT VT meter incorrectly connected in a 3-phase, 4-wire network and an Argand diagram representing the measured values.
FIG. 6 illustrates another example chart with measured values by a CT VT meter incorrectly connected in a 3-phase, 4-wire network and an Argand diagram representing the measured values.
FIG. 7 illustrates another example chart with measured values by a CT VT meter connected with multiple wiring errors in a 3-phase, 4-wire network and an Argand diagram representing the measured values.
FIG. 8 illustrates an example process performed by an electricity meter for detecting wiring errors and providing virtual re-configuration for corrected measurements.
FIG. 9 illustrates an example chart of incorrect wiring and graphs of power factors associated with the correct wiring and the incorrect wiring.
FIG. 10 illustrates an example schematic diagram of virtual distribution re-configuration for a CT VT meter correctly connected to a 3-phase, 4-wire network.
FIG. 11 illustrates an example schematic diagram of virtual distribution re-configuration for a CT VT meter where the voltage channels are connected correctly as but one current channel is reversed.

FIG. 12 illustrates an example schematic diagram of virtual distribution re-configuration for a CT VT meter, where the voltage channels are connected correctly but the channels are currently shifted.

FIG. 13 illustrates an example block diagram of a CT VT meter capable of generating virtual distribution re-configuration.

## DETAILED DESCRIPTION

A method and apparatus for analyzing electricity meter connections and correction thereof are provided, more specifically, when a connection/wiring error is detected, a virtual voltage distribution re-configuration and/or a virtual current distribution re-configuration are generated, and a corrected, power consumption based on at least one of the virtual voltage distribution re-configuration or the virtual current distribution re-configuration is calculated in an auxiliary register of the electricity meter.

Electricity meters have separated current and voltage inputs when the grid voltage and/or current is higher than the maximum voltage and/or current admissible for a DC meter, for example, in a Medium or High voltage grid, where instrument transformers, such as CTs, VTs, or low power instrument transformers (LPITs), are utilized. These instrument transformers are inserted between the grid and the meter voltage and current terminals.

When an electricity meter, such as an LV CT meter, or CT VT meter, is incorrectly wired, the reading from the electricity meter may include errors resulting in lower calculated and registered energy due to the NTLs. Generally, these errors are detected at the time of the installation and corrected using a field tool software that provides vector diagrams of the voltage and current (Argand, or Fresnel, diagram plane), where a 3-phase voltage and current diagram generated by the field tool software indicates whether the connections to the electricity meter are correct. However, there are occasion when the wirings are tampered with to affect the energy billings.

While an existence of wiring errors may be detected and often correctly analyzed, the analysis of an Argand diagram may be further complicated due to possible combinations of multiple wiring errors. These combinations may be categorized into four groups, interruption, inverse current flow, phase permutation, and circular permutation. The interruption may include a condition where one or more of the connections is missing. For example, three voltages, $V_A$, $V_B$, and $V_C$ may be correctly connected while one of the corresponding currents, $I_A$, $I_B$, and $I_C$ may be missing (0, $I_B$, $I_C$). The inverse current flow may be due to one of the currents being reversed, for example, for the three voltages ($V_A$, $V_B$, $V_C$), the corresponding three currents may be ($-I_A$, $I_B$, $I_C$). The phase permutation may include any one or more pairs being switched, $V_A$ and $V_B$, $V_B$ and $V_C$, $V_C$ and $V_A$, $I_A$ and $I_B$, $I_B$ and $I_C$, and $I_C$ and $I_A$. The circular permutation may include ($V_A$, $V_B$, $V_C$) with ($I_B$, $I_C$, $I_A$) or ($I_C$, $I_A$, $I_B$).

NTLs are losses due to abnormal metering situations, for example, tampering by an intentional wrong connection. To detect this type of tampering, the correct wiring/connection of a meter must be performed periodically. However, given that a utility company typically manages hundreds or thousands of customers and associated meters, it is not feasible to periodically perform a wiring check on each of the installed meters. Even if the wiring of a meter is verified, the meter may still be tampered to a corrupted wiring such that the energy bill of the customer associated with the meter is fraudulently lowered. For example, for a meter connected to a 3-phase 4-wire network, the voltage and current terminals may first be correctly connected as a voltage vector sequence of (V1, V2, V3) with a current vector sequence of (I1, I2, I3). However, the wiring may be tampered by performing a circular shift of the currents such that the meter is now connected as a voltage vector sequence of (V1, V2, V3) with a current vector sequence of (I2, I3, I1), which may reduce the active energy registered by the meter by 50%.

Currently, a polyphase electricity meter may be analyzed with an external tool utilizing the Argand diagram plane of six quantities, three voltage vectors and three current vectors, to determine whether the meter is correctly connected to the network. If the meter is determined to be correctly connected to the network, then the registered active energy consumption would be correct. A polyphase electricity meter, such as a CT VT meter disclosed herein, may analyze the Argand diagram plane of the same six quantities, three voltage vectors and three current vectors, to determine whether the CT VT meter is correctly connected to the network. As before, if the CT VT meter is determined to be correctly connected to the network, then the registered active energy consumption would be correct. However, if the CT VT meter is determined to be incorrectly connected to the network, the CV VT meter may provide a virtual re-configuration of the connections, independent of the physical connections to the meter terminals, to produce corrected active energy consumption in an auxiliary register in addition to the active energy measured based on the current connections in a main or primary register.

The CT VT meter may periodically verify the Argand diagram(s) to monitor the connection of the neutral terminal, balance the amplitude and the positive sequence of the three voltage vectors, monitor the position of each current vector in the four quadrants corresponding to a customer usage. When a wiring error is detected, CT VT meter may generate a virtual distribution re-configuration of the inputs of CT VT meter (proposed re-configuration) and an indication of the nature of the wiring error, such as an inversion between the phase of voltage vector V1 and the phase of the voltage vector V2, the phase of the current vector I3 in the opposite direction, etc. In parallel, the CT VT meter may calculate the corrected active energy on an auxiliary energy register of the CT VT meter based on the proposed re-configuration and calculate a ratio of the corrected active energy to the active energy measured in the actual, i.e., as currently connected, configuration. If this ratio is higher than 1, it may indicate that the wiring is different from the intended configuration introducing an error, and the CT VT meter may generate an alarm to notify the DSO for a possible tampering of the CT VT meter. The CT VT meter may transmit all the information associated with the Argand diagrams before and after generating the virtual voltage and virtual current distribution re-configurations of the terminals, and may also indicate the corrected active energy in addition to the active energy measured as currently connected. The transmitted information may aide the DSO in understanding the cause of the detected abnormal wiring and repairing the physically altered connections of the terminals of the CT VT meter. Once the wiring, or the connections to the terminals of the CT VT meter, is corrected, the CT VT meter may restart and begin monitoring and computing each metrology. By periodically executing the process above, incorrect wiring, which may possibly be an intentional tampering of the wiring, may be detected near real-time.

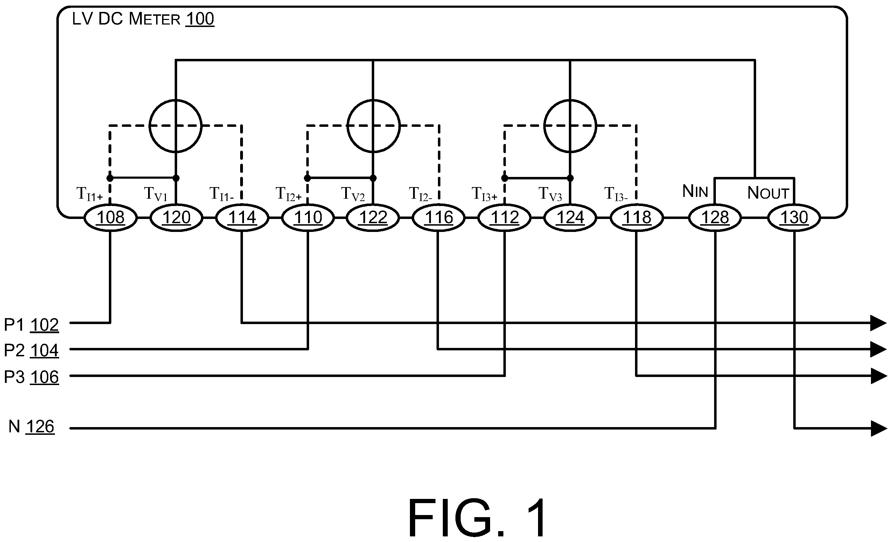

FIG. 1 illustrates an example LV DC meter 100 for low voltage networks. Three power lines, P1 102, P2 104, and P3 106, each carrying up to 600V and up to 120A, are connected directly to input current terminals $T_{I1}+$ 108, $T_{I2}+$ 110, and $T_{I3}+$ 112, respectively, of the LV DC meter 100. Output current terminals $T_{I1-}$ 114, $T_{I2-}$ 116, and $T_{I3-}$ 118 are coupled to their corresponding input current terminals $T_{I1}+$ 108, $T_{I2}+$ 110, and $T_{I3}+$ 112 of the LV DC meter 100, and the current of each line is monitored between each current terminal pair. Voltage terminals $T_{V1}$ 120, $T_{V2}$ 122, and $T_{V3}$ 124 of the LV DC meter 100 are internally linked to the corresponding input current terminals $T_{I1}+$ 108, $T_{I2}+$ 110, and $T_{I3}+$ 112, and the voltage of each line is monitored relative to a neutral line N 126 connected through an input neutral terminal $N_{IN}$ 128 and $N_{OUT}$ 128.

In a DC meter, such as the LV DC meter 100, wiring errors typically come from permutation between phases, which ultimately introduces an error in the rotation of the three phase system (a negative sequence instead of a positive sequence for the three phases system), however, it does not affect the power or energies (active and reactive) registered by the LV DC meter 100.

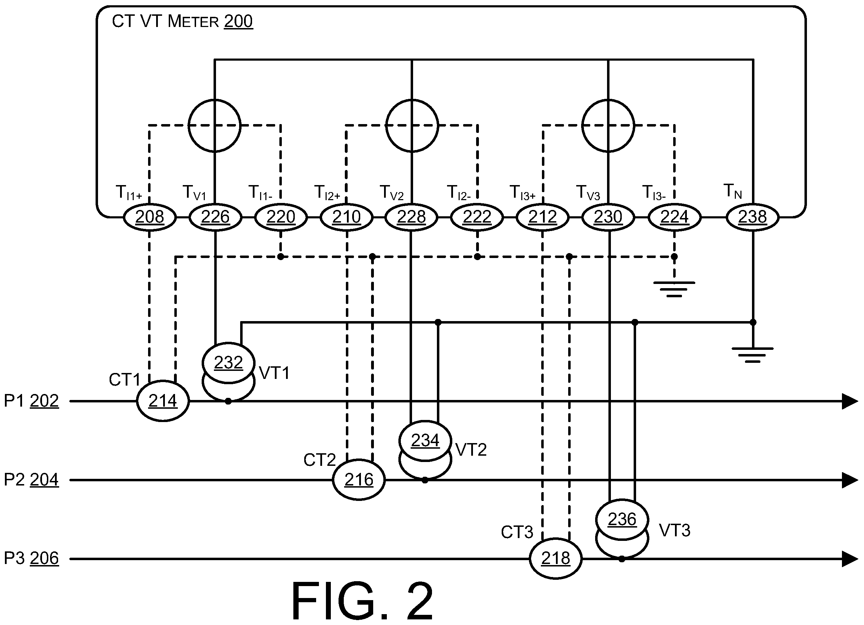

FIG. 2 illustrates an example 3-phase CT VT meter 200 for medium to high voltage networks. Three power lines, P1 202, P2 204, and P3 206, each carrying up to 200kV and up to 1kA, are coupled to input current terminals of the CT VT meter 200 $T_{I1}+$ 208, $T_{I2}+$ 210, and $T_{I3}+$ 212, respectively by non-grounding terminals of corresponding current transformers CT1 214, CT2 216, and CT3 218. Output current terminals $T_{I1-}$ 220, $T_{I2-}$ 222, and $T_{I3-}$ 224 are grounded along with grounding terminals of the CTs 214, 216, and 218. The power lines, P1 202, P2 204, and P3 206 are also coupled to voltage terminals of the CT VT meter 200 $T_{V1}$ 226, $T_{V2}$ 228, and $T_{V3}$ 230, respectively by non-grounding terminals of corresponding voltage transformers VT1 232, VT2 234, and VT3 232. Grounding side of the voltage transformers VT1 232, VT2 234, and VT3 232 are connected to the ground along with a neutral terminal $T_N$ 238 of the CT VT meter 200.

In a CT VT meter, such as the CT VT meter 200, there are various possible wiring errors causing an incorrectly connected voltage to be associated with a correctly connected current and/or incorrect current circulation directions, which may occur with one or more phases.

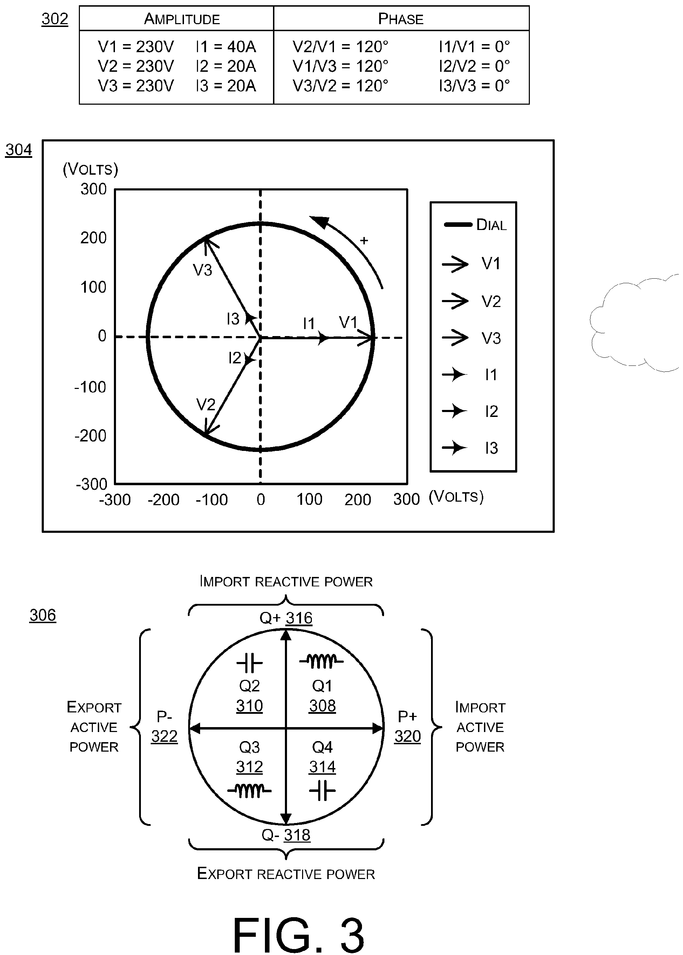

FIG. 3 illustrates example analysis diagrams for a 3-phase, 4-wire network in which voltage and current vectors are represented in a complex plane. Values of amplitude and phase values for the voltages and currents for the a 3-phase 4-wire network are shown in a chart 302, and are represented as vectors in the Argand diagram 304.

A metrology quadrant chart 306 illustrates quadrants, Q1 308, Q2 310. Q3 312, and Q4 314, corresponding to different meter usages. An analysis of the Argand diagram 304 may conclude that the meter, such as the CT VT meter 200, is connected correctly if, for each phase, the voltage and current are in a proper quadrant of the Argand diagram 304 corresponding to the meter usage, or that the meter is not connected correctly if voltage and current are not where they are expected to be for the particular meter usage. In the metrology quadrant chart 306, the top half, Q+ 316 including Q1 308 and Q2 310, represents import reactive power, the bottom half, Q- 318 including Q3 312 and Q4 314, represents export reactive power, the right half P+ 320 including Q1 308 and Q4 314, represents import active power, and the left half, P- 322 including Q2 310 and Q3 312, represents export active power.

For example, for a meter measuring the energy consumed by a load, the voltage and current vectors must be in Q1 308 and Q4 314 for each phase. For a meter measuring the energy generated by a producer, the voltage and current must be in Q2 310 and Q3 312 for each phase.

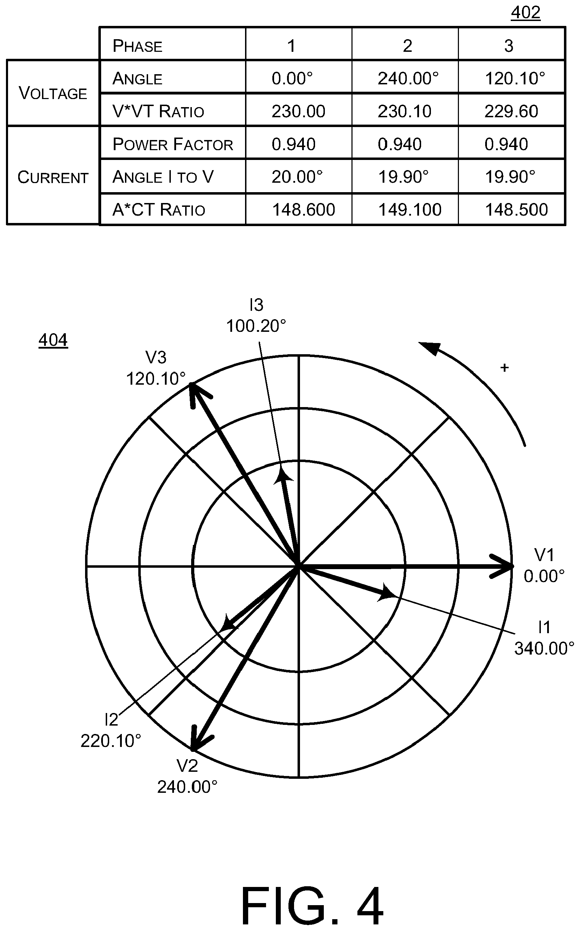

FIG. 4 illustrates an example chart 402 with measured values by a CT VT meter, such as the CT VT meter 200, correctly connected in a 3-phase 4-wire network and an Argand diagram 404 representing the measured values. In this example, the voltage vectors, V1, V2, and V3, and the current vectors, I1, 12, and 13 are both in a positive sequence, i.e., a clockwise rotation, and the power factors for (V1, I1), (V2, 12), and (V3, 13) are identical in Q1, thus indicating an active import.

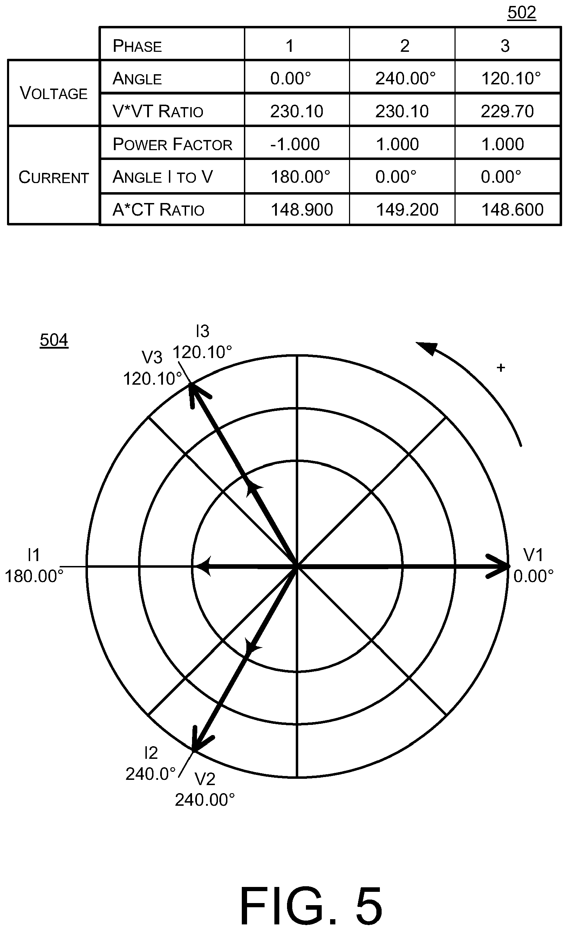

FIG. 5 illustrates an example chart 502 with measured values by a CT VT meter, such as the CT VT meter 200, incorrectly connected in a 3-phase 4-wire network and an Argand diagram 504 representing the measured values.

In this example, the voltage vectors, V1, V2, and V3 are in a positive sequence, i.e., a clockwise rotation, and power factors for (V2, 12) and (V3, 13) are identical and very close to the power factor (V1, I1). However, the current vectors, I1, 12, and 13 are not in a positive sequence, that is, I1 is pointing in the opposite direction, which indicates that the current sensor for the phase 1 is reversed.

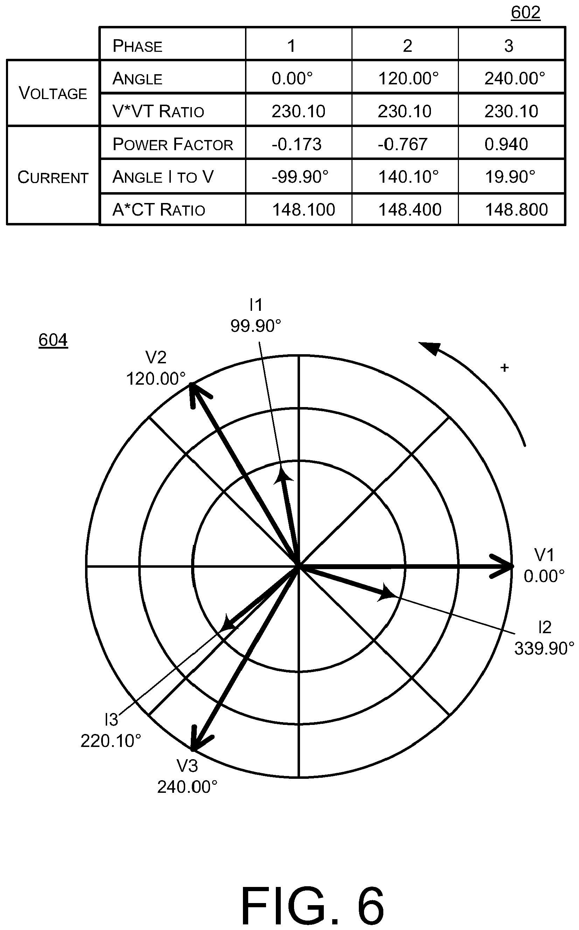

FIG. 6 illustrates another example chart 602 with measured values by a CT VT meter, such as the CT VT meter 200, incorrectly connected in a 3-phase 4-wire network and an Argand diagram 604 representing the measured values. In this example, the voltage vectors, V1, V2, and V3 are in a negative sequence, i.e., a counter-clockwise rotation while the current vectors, I1, 12, and 13, are in a positive sequence, i.e., a clockwise rotation. The power factor for (V1, I1) is in Q3 and the power factor for (V2,12) is in Q2, both indicating an active export. However, the power factor for (V3, 13) is in Q1 indicating an active import. Therefore, the Argand diagram indicates that the connections for V1 and V2 are switched.

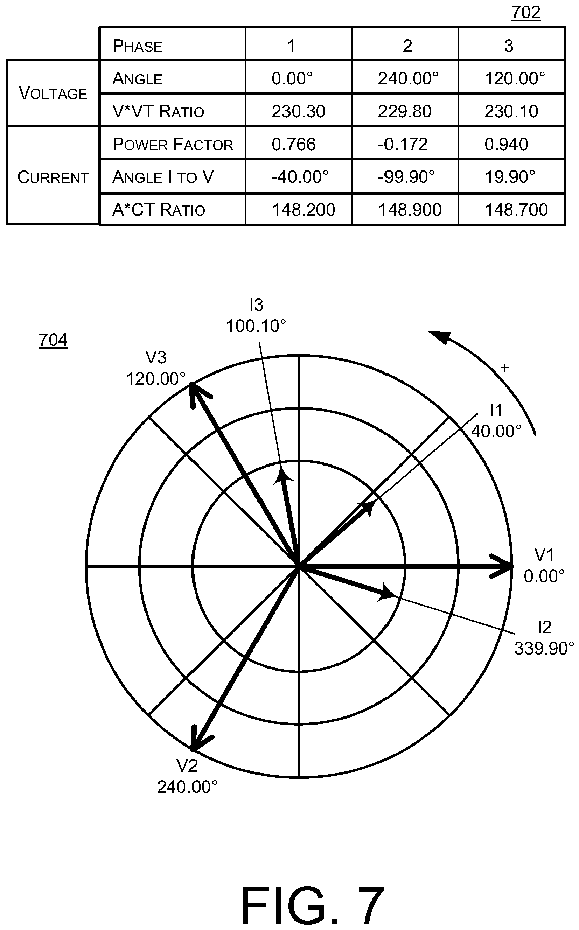

FIG. 7 illustrates another example chart 702 with measured values by a CT VT meter, such as the CT VT meter 200, connected with multiple wiring errors in a 3-phase 4-wire network and an Argand diagram 704 representing the measured values. In this example, the connections for $V_A$ and $V_B$ are switched, and the connection for $I_A$ is reversed, resulting in the current vector I1 corresponding to $I_A$ displayed off 180°, V1 corresponding to $V_A$ displayed close to 12, V2 corresponding to $V_B$ displayed close to the opposite of I1.

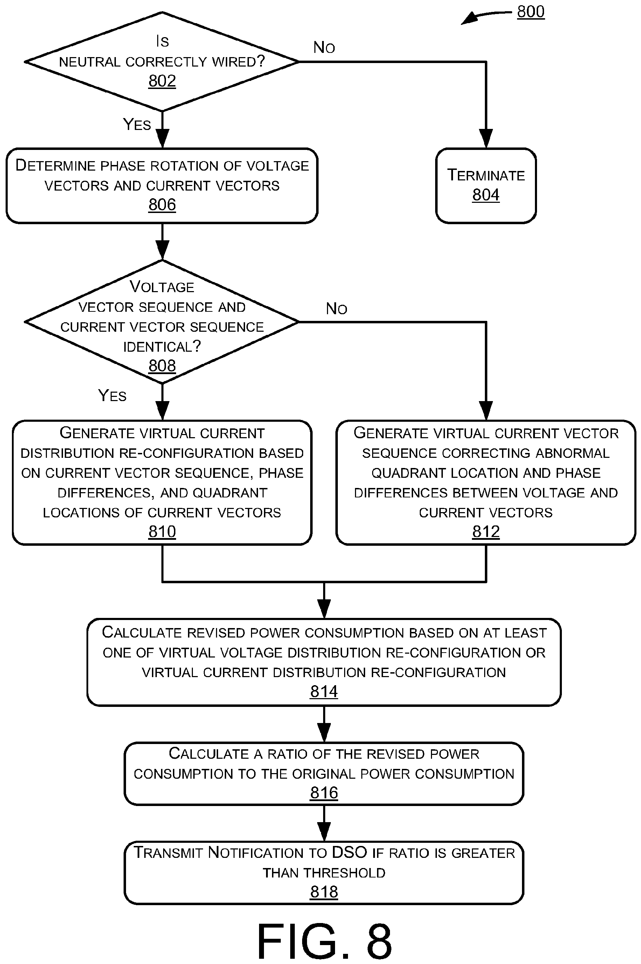

FIG. 8 illustrates an example process 800 performed by an electricity meter, such as the CT VT meter 200, for detecting wiring errors and providing virtual re-configuration for corrected measurements.

At block 802, whether a neutral terminal, such as the neutral terminal $T_N$ 238 of the CT VT meter 200, is correctly wired may be determined. Whether a respective amplitude, or voltage, monitored at each voltage terminal of the plurality of voltage terminals, such as $T_{V1}$ 226, $T_{V2}$ 228, and $T_{V3}$ 230, is within a predetermined range of a nominal value, may be determined. The predetermined range may compensate for a measurement tolerance, for example, +/- 15%, and the nominal value may be 230Vrms. If at least one amplitude is not within the predetermined range of the nominal value, the neutral terminal 238 may be determined to be incorrectly connected. For example, the neutral line normally connected to the neutral terminal 238 may be disconnected or swapped with one of active lines. Because this type of wiring errors requires physical wiring re-connection, the process may generate an alarm, which may be transmitted to the DSO responsible for the CT VT meter 200 notifying of the wiring errors, and terminate at block 804. Technicians may then be sent to correct the wiring errors.

If each amplitude is determined to be within the predetermined range of the nominal value, the neutral terminal 238 may be determined to be correctly connected, and the process may proceed to block 806. When the neutral terminal 238 is correctly connected, i.e., connected to the ground, there are six possible voltage connection combinations for a 3-phase 4-wire network with three combinations having a positive voltage vector sequence, (V1, V2, V3), (V2, V3, V1), and (V3, V1, V2) and three having a negative voltage vector sequence (V1, V3, V2), (V2, V1, V3), and (V3, V2, V1).

At block 806, a phase rotation of the voltage vectors and the current vectors may be determined. The voltage vectors V1, V2, and V3, monitored at the voltage terminals $T_{V1}$ 226, $T_{V2}$ 228, and $T_{V3}$ 230 of the CT VT meter 200, may be determined and a rotation of the voltage vectors V1, V2, and V3, or a voltage vector sequence, may be determined based on the voltage vectors presented on the Argand diagram. Similarly, the current vectors, I1, 12, and 13, monitored at the current terminals $T_{I1}$+ 208, $T_{I2}$+ 210, and $T_{I3}$+ 212 of the CT VT meter 200, may be determined and a rotation of the current vectors I1, 12, and 13, or a current vector sequence, may be determined based on the current vectors presented on the Argand diagram. The analysis may be based on Fortescue transformation where an unbalanced set of three related phasors (voltage or current vectors) are resolved into three systems of symmetrical components, where the three systems comprise a positive sequence, a negative sequence , and a zero sequence.

For the phase rotation to be determined as a counter-clockwise rotation, i.e., a negative sequence, for the voltage vector sequence of V1, V2, and V3, the following conditions must be met:

1) the angles measured from V1 to V2, from V2 to V3, and from V3 to V1, each being +120° +/- predetermined voltage phase tolerance;
2) the amplitude of three systems of symmetrical components, the positive sequence, the negative sequence, and the zero sequence of the voltage, where the amplitude of the negative sequence is the largest, and the amplitudes of the positive and the zero sequences are expressed as a percentage of the amplitude of the negative sequence;
3) the angles measured from I1 to I2, from I2 to I3, and from I3 to I1, each being +120° +/- predetermined current phase tolerance;
4) the amplitude of three systems of symmetrical components, the positive sequence, the negative sequence, and the zero sequence of the current, where the amplitude of the negative sequence is the largest, and the amplitudes of the positive and the zero sequences are expressed as a percentage of the amplitude of the negative sequence; and
5) the negative sequence of the currents is dominant.

For the phase rotation to be determined as a clockwise rotation, i.e., a positive sequence, for the voltage vector sequence of V1, V2, and V3, the following conditions must be met:

1) the angles measured from V1 to V2, from V2 to V3, and from V3 to V1, each being -120° +/- predetermined voltage phase tolerance;
2) the amplitude of three systems of symmetrical components, the positive sequence, the negative sequence, and the zero sequence of the voltage, where the amplitude of the positive sequence is the largest, and the amplitudes of the negative and the zero sequences are expressed as a percentage of the amplitude of the positive sequence;
3) the angles measured from I1 to I2, from I2 to I3, and from I3 to I1, each being -120° +/- predetermined current phase tolerance;
4) the amplitude of three systems of symmetrical components, the positive sequence, the negative sequence, and the zero sequence of the current, where the amplitude of the positive sequence is the largest, and the amplitudes of the negative and the zero sequences are expressed as a percentage of the amplitude of the positive sequence; and
5) the positive sequence of the currents is dominant.

In addition, a phase difference between each of the voltage vector and its corresponding current vector and a quadrant location of each current vector may also be determined at block 806. As described above with reference to the metrology quadrant chart 306 in FIG. 3, the quadrant locations of the current vectors indicate whether the CT VT meter 200 is measuring the energy producer side (the energy supplier) or the energy consumer side (the utility customer). Therefore, if at least one of the quadrant location is different from an expected location, it indicates that the CT VT meter 200 is incorrectly connected. The CT VT meter 200 may also generate another alarm in response to determining that, at least one of, the voltage vector sequence is a negative sequence, the current sequence is a negative sequence, or at least one determined quadrant location is different from the expected quadrant location.

At block 808, the process takes a separate path based on whether the voltage vector sequence and the current vector sequence are identical. If the sequences are identical, the process proceeds to block 810, and a virtual voltage distribution re-configuration, or a virtual voltage vector sequence, may be generated based upon the current vector sequence, the phase differences between voltage vectors and the corresponding current vectors, and the quadrant locations of the current vectors. The virtual voltage distribution re-configuration may indicate two or more voltage lines to be connected to voltage terminals that are different from currently connected voltage terminals. If the sequences are not identical, the process proceeds to block 812, and a virtual current distribution re-configuration, or a virtual current vector sequence, may be generated. The virtual current vector sequence may be generated based upon the current vector sequence, the phase differences between voltage vectors and the corresponding current vectors, and the quadrant locations of the current vectors, correcting an abnormal quadrant location and phase differences between the voltage vectors and the current vectors. The virtual current distribution re-configuration may indicate at least one current line to be re-connected to another current terminal. The virtual voltage distribution re-configuration and the virtual current distribution re-configuration may be stored locally at the CT VT meter 200, and/or transmitted to the DSO and stored at the DSO. The stored re-configuration information may be accessed and used when a technician is sent to physically correct the wiring connections.

The process may then proceed from block 810 or block 812 to block 814 and a revised power consumption may be calculated based at least one of the virtual voltage distribution re-configuration or the virtual current distribution re-configuration. This calculation may take place in an auxiliary register of the CT VT meter 200, while the primary register of the CT VT meter 200 continues to monitor and calculate an original power consumption based on the voltage vectors in the determined voltage vector sequence and the current vectors in the determined current vector sequence. Therefore, the DSO may be able obtain the revised, or corrected, power consumption upon detecting a wiring connection error without physically re-connecting the CT VT meter 200 correctly.

At block 816, a ratio of the revised power consumption to the original power consumption may be calculated. If the ratio is greater than a threshold value, the CT VT meter 200 may generate a notification indicative of incorrect wirings at the voltage terminals or the current terminals and transmit the notification to the DSO at block 818.

For a 3-phase, 4-wire network, when the active power is calibrated, that is to compensate for the gain errors of the voltage and current paths introduced by various components, such as sensors, front-end analog-to-digital converters (ADCs), and digital filters, and the like, voltage calibration parameters, $k_{Vl}$, (where $l$ = 1, 2, 3) and current calibration parameter $k_{Im}$, (where $m$ = 1, 2, 3) may be utilized. For individual voltage phase corrections, phase calibration parameters, $k_{\phi n}$ (where $n$ = 1, 2, 3) may be utilized.

If $V_A$, $V_B$, $V_C$, and N, where N is neutral and grounded, are the four voltage points of the meter terminals and V1, V2, and V3 are the three internal metrology quantities, then a 3x3 matrix M(V) transforming ($V_A$, $V_B$, $V_C$) to (V1, V2, V3) is diagonal: $k_{V1}$, $k_{V2}$, and $k_{V3}$.

$$M(V) = \begin{bmatrix} k_{V1} & 0 & 0 \\ 0 & k_{V2} & 0 \\ 0 & 0 & k_{V3} \end{bmatrix} \tag{1}$$

If the Argand diagram analysis concludes that two voltages must be swapped, the positions in the columns are also swapped, $k_{V1}$ stays in the first column, $k_{V2}$ in the second column, and $k_{V3}$ in the third column. The 3x3 matrix M(V) transforming ($V_A$, $V_B$, $V_C$) to (V1, V2, V3) for a case of inversion of $V_A$ and $V_B$ inputs is:

$$M(V)_{12} = \begin{bmatrix} 0 & k_{V2} & 0 \\ k_{V1} & 0 & 0 \\ 0 & 0 & k_{V3} \end{bmatrix} \tag{2}$$

This principle applies to any permutation and any circular shift, and the same principle applies to the current channels, the 3x3 matrix M(I) transforming ($I_1$, $I_B$, $I_C$) to ($I_1$, $I_2$, $I_3$), is diagonal: kn, $k_{I2}$, and $k_{I3}$.

$$M(I) = \begin{bmatrix} k_{I1} & 0 & 0 \\ 0 & k_{I2} & 0 \\ 0 & 0 & k_{I3} \end{bmatrix} \tag{3}$$

If a current channel/connection is reversed, the corresponding calibration parameter is multiplied by -1, for example, in a case of an inversion on $I_A$.

$$M(I)_{-1} = \begin{bmatrix} -k_{I1} & 0 & 0 \\ 0 & k_{I2} & 0 \\ 0 & 0 & k_{I3} \end{bmatrix} \tag{4}$$

If two current connections, for example, $I_A$ and $I_B$, were swapped, the corresponding row positions of the calibration parameters for $I_A$ and $I_B$ in the columns would be swapped while the column positions remain the same.

$$M(I)_{12} = \begin{bmatrix} 0 & k_{I2} & 0 \\ k_{I1} & 0 & 0 \\ 0 & 0 & k_{I3} \end{bmatrix} \tag{5}$$

If the conversion matrices M(V) and M(I) have only diagonal terms + 1 or -1, no complementary phase correction (inter-phases voltage phase correction) is necessary. However, if the conversion matrix has non-diagonal terms V or I, a complementary phase correction is necessary in addition to individual voltage phase correction parameters, $k_{\phi1}$, $k_{\phi2}$, and $k_{\phi3}$. The complementary phase correction, or inter-phases voltage phase correction, parameters are, for example, $k_{\phi12}$ for a phase correction between V1 and V2, $k_{\phi23}$ for a phase correction between V2 and V3, and $k_{\phi31}$ for a phase correction between V3 and V1. Note that $k_{\phi31}$ is also equal to - ($k_{\phi12}$ + $k_{\phi23}$), thus only two complementary phase correction parameters, $k_{\phi12}$ and $k_{\phi23}$, need to be defined.

These calibration parameters, $k_{V1}$, $k_{V2}$, $k_{V3}$, $k_{I1}$, $k_{I2}$, $k_{I3}$, $k_{\phi1}$, $k_{\phi2}$, $k_{\phi3}$, $k_{\phi12}$, and $k_{\phi23}$, may be store locally in the CT VT meter 200 during a manufacturing routine test to maintain accuracy of the CV VT meter 200 in operation.

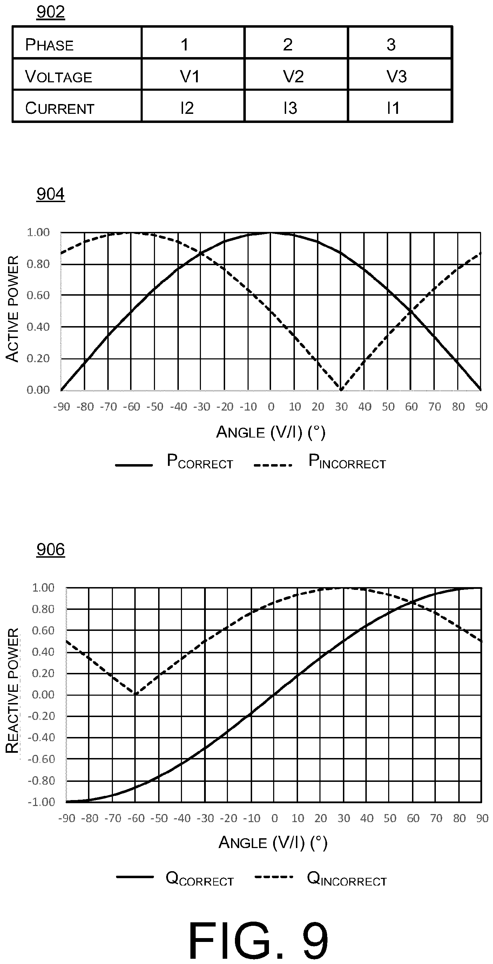

FIG. 9 illustrates an example chart 902 of incorrect wiring of a CT VT meter, where the current connections are shifted, and graphs 904 and 906 of active and reactive power factors associated with the correct wiring and incorrect wiring for a 3-phase, 4-wire network.

The chart 902 shows that, while all three voltages are connected correctly, the currents are shifted by one, that is I2 is connected in place of I1, I3 is connected in place of I2, and I1 is connected in place I3. In a 3-phase, 4-wire network, the above configuration would result in the voltage vectors and the current vectors having the same rotation but the current vectors would be shifted by 120°. The x-axes of the graphs 904 and 906 show the phase shift between the voltage and the current of the corresponding pairs, V1 - I1, V2 - 12, and V3 - 13, y-axis of the graph 904 shows the power factor, and the y-axis of the graph 904 shows the reactive power factor. For both graphs 904 and 906, the solid line represents the response for the correct wiring, i.e., V1*I1, V2*I2, and V3*I3, and the dashed line represents the incorrect wiring, i.e., V1*I2, V2*I3, and V3*I1 for this example. As shown in the graph 904, at power factor =1, the active energy for the incorrect wiring is 50% of the active energy for the correct wiring, and for a large interval in phase, for example from -30° to +60°, the active energy for the incorrect wiring is significantly lower than that of the correct wiring.

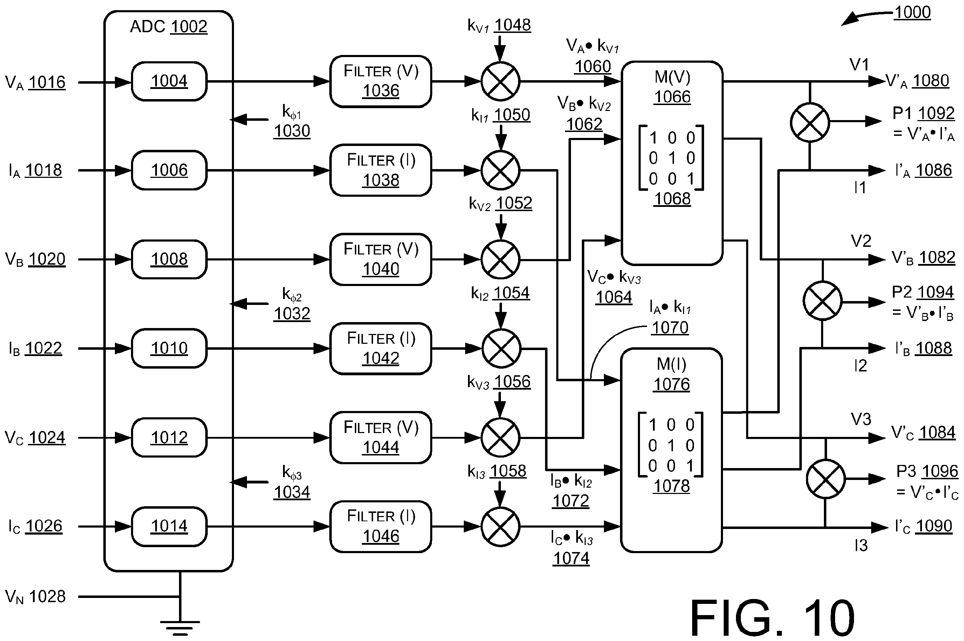

FIG. 10 illustrates an example schematic diagram 1000 of virtual distribution re-configuration for a CT VT meter, such as the CT VT meter 200, correctly connected to a 3-phase, 4-wire network as discussed above.

An ADC 1002 may have six channels 1004, 1006, 1008, 1010, 1012, and 1014 for three voltage and current pairs $V_A$ 1016 and $I_A$ 1018, $V_B$ 1020 and $I_B$ 1022, and Vc 1024 and Ic 1026. The ADC 1002 may be grounded with a neutral line $V_N$ 1028. To compensate for a phase difference between the voltage and current pairs, $(V_A, I_A)$, $(V_B, I_B)$, and $(V_C, I_C)$, phase calibration parameters $k_{\phi 1}$ 1030, $k_{\phi 2}$ 1032, and $k_{\phi 3}$ 1034 may also be introduced to the ADC 1002. Outputs from the ADC 1002 for $V_A$ 1016, $I_A$ 1018, $V_B$ 1020, $I_B$ 1022, $V_C$ 1024, and $I_C$ 1026 may be fed to respective voltage or current numerical filters, 1036, 1038, 1040, 1042, 1044, and 1046, and their outputs may be compensated by the respective calibration parameters $k_{V1}$ 1048, $k_{I1}$ 1050, $k_{V2}$ 1052, $k_{I2}$ 1054 $k_{V3}$ 1056, and $k_{I3}$ 1058.

Calibrated outputs for the voltages, 1060 $(V_A \cdot k_{V1})$, 1062 $(V_B \cdot k_{V2})$, and 1062 $(V_C \cdot k_{V3})$, may then be operated by a 3x3 voltage matrix M(V) 1066, which is an identity matrix 1068, to transform $(V_A, V_B, V_C)$ to (V1, V2, V3) in a virtual voltage distribution re-configuration, which may include correction(s) to the input configuration of $(V_A, V_B, V_C)$ as shown above. Similarly, calibrated outputs for the currents, 1070$(I_A \cdot k_{I1})$, 1072 $(I_B \cdot k_{I2})$, and 1074 $(I_C \cdot k_{I3})$, may then be operated by a 3x3 current matrix M(I) 1076, which is an identity matrix 1078, to transform $(I_A, I_B, I_C)$ to (I1, 12, 13) in a virtual current distribution re-configuration, which may include correction(s) to the input configuration of $(I_A, I_B, I_C)$. In this example, analyses of the Argand diagram of voltage vectors and the current vectors may indicate that $V_A$ 1016, $I_A$ 1018, $V_B$ 1020, $I_B$ 1022, $V_C$ 1024, and $I_C$ 1026 are correctly connected, and the voltage matrix M(V) 1066 and the current matrix M(I) 1076 are identity matrices 1068 and 1078, respectively, as shown. The voltage matrix M(V) 1066 then outputs V1, V2, and V3 as the calibrated $V_A$ 1016 ($V'_A$ 1080), $V_B$ 1020 ($V'_B$ 1082), and $V_C$ 1024 ($V'_C$ 1084), and the current matrix M(I) 1076 outputs I1, 12, and 13 as the calibrated $I_A$ 1018 ($I'A$ 1086), $I_B$ 1022 ($I'_B$ 1088), and $I_C$ 1026 ($I'_C$ 1090). The instantaneous power P1 1092, P2 1094, and P3 1096 may then be determined based on the instantaneous products of the calibrated voltage-current output pairs $(V'_A, I'_A)$, $(V'_B, I'_B)$, and $(V'_C, I'_C)$.

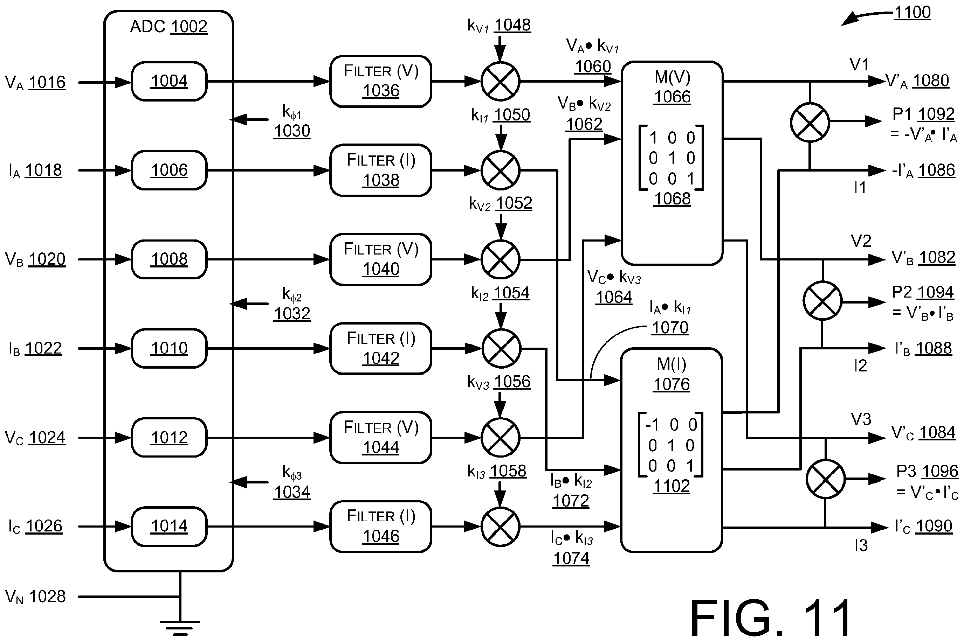

FIG. 11 illustrates an example schematic diagram 1100 of virtual distribution re-configuration for a CT VT meter, such as the CT VT meter 200, where the voltage channels are connected correctly as $(V_A, V_B, V_C)$ but one current channel, $I_A$, is reversed as $(-I_A, I_B, I_C)$.

In this example, $V_A$ 1016, $V_B$ 1020, and $V_C$ 1024 are correctly connected to the corresponding ADC channels 1004, 1008, and 1012, respectively. However, while $I_A$ 1018, $I_B$ 1022, and $I_C$ 1026 are connected to the correct corresponding channels 1010, 1012, and 1014, respectively, the analyses of the Argand diagram of voltage vectors and the current vectors indicate that, $I_A$ 1018 is reversed. Therefore, the voltage matrix M(V) 1066 is an identity matrix 1068, but the current matrix M(I) 1076 must be a non-diagonal current matrix 1102 as shown below.

$$M(I) = \begin{bmatrix} -1 & 0 & 0 \\ 0 & 1 & 0 \\ 0 & 0 & 1 \end{bmatrix} \quad\quad\quad (6)$$

As in FIG. 10, the voltage matrix M(V) 1066 then outputs V1, V2, and V3 as the calibrated $V_A$ 1016 ($V'_A$ 1080), $V_B$ 1020 ($V'_B$ 1082), and $V_C$ 1024 ($V'_C$ 1084), but the current matrix M(I) 1076 outputs I1, 12, and 13 as the calibrated $I_A$ 1018 ($-I'_A$ 1086), $I_B$ 1022 ($I'_B$ 1088), and $I_C$ 1026 ($I'_C$ 1090). The instantaneous power P1 1092, P2 1094, and P3 1096 may then be determined based on the instantaneous products of the calibrated voltage-current output pairs $(V'_A, -I'_A)$, $(V'_B, I'_B)$, and $(V'_C, I'_C)$.

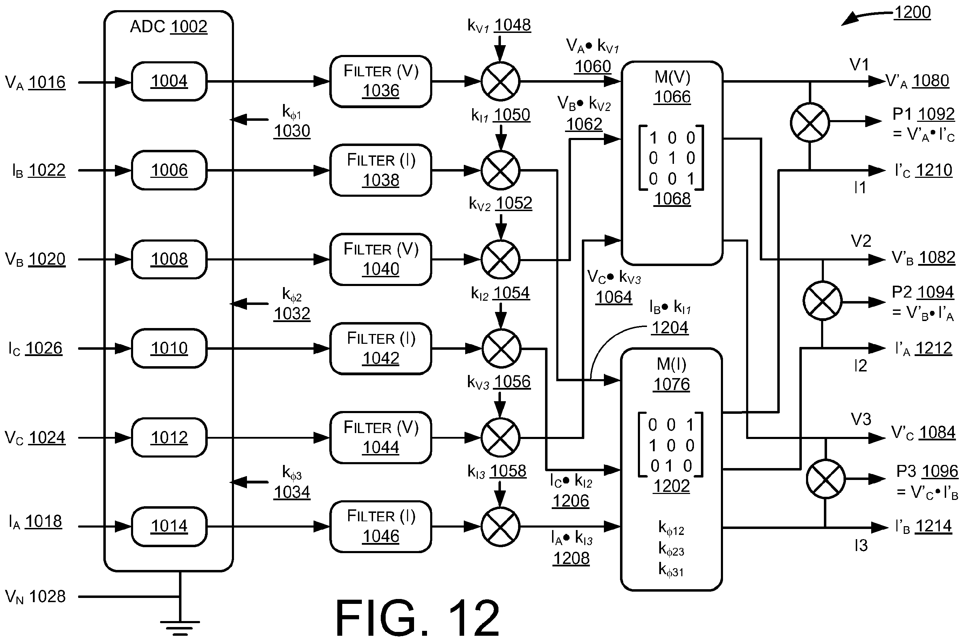

FIG. 12 illustrates an example schematic diagram 1200 of virtual distribution re-configuration for a CT VT meter, such as the CT VT meter 200, where the voltage channels are connected correctly as $(V_A, V_B, V_C)$ but the currently channels are shifted as $(I_B, I_C, I_A)$.

In this example, $V_A$ 1016, $V_B$ 1020, and Vc 1024 are correctly connected to the corresponding ADC channels 1004, 1008, and 1012, respectively. However, $I_A$ 1018, $I_B$ 1022, and Ic 1026 are shifted as $(I_B, I_C, I_A)$, and, as a result, $I_A$ 1018 is connected to the channel 1014, $I_B$ 1022 is connected th the channel 1006, and Ic 1026 is connected to the channel 1010. The analyses of the Argand diagram of voltage vectors and the current vectors may indicate that, while $V_A$ 1016, $V_B$ 1020, and Vc 1024 are correctly connected as $(V_A, V_B, V_C)$, $I_A$ 1018, $I_B$ 1022, and $I_C$ 1026 are shifted as $(I_B, I_C, I_A)$. Therefore, the voltage matrix M(V) 1066 is an identity matrix 1068, but the current matrix M(I) 1076 must be a non-diagonal current matrix 1202 as shown below.

$$M(I) = \begin{bmatrix} 0 & 0 & 1 \\ 1 & 0 & 0 \\ 0 & 1 & 0 \end{bmatrix} \qquad\qquad (7)$$

As in FIG. 10, the calibrated outputs for the voltages, 1060 ($V_A \cdot k_{V1}$), 1062 ($V_B \cdot k_{V2}$), and 1062 ($V_C \cdot k_{V3}$), may then be operated by a 3x3 voltage matrix M(V) 1066, which is an identity matrix 1068, to transform ($V_A$, $V_B$, $V_C$) to (V1, V2, V3) in a virtual voltage distribution re-configuration, which may include correction(s) to the input configuration of ($V_A$, $V_B$, $V_C$) as shown above. However, because of the shift, the calibrated outputs for the current are 1204 ($I_B \cdot k_{I1}$), 1206 ($I_C \cdot k_{I2}$), and 1208 ($I_A \cdot k_{I3}$), where each current component is calibrated with a mismatched calibration parameter. To correct the errors due to mismatch, the corresponding complementary phase correction, $k\phi_{12}$ for the phase correction between V1 and V2, $k\phi_{23}$ for the phase correction between V2 and V3, and $k\phi_{31}$ for the phase correction between V3 and V1 as described above are applied to 1204 ($I_B \cdot k_{I1}$), 1206 ($I_C \cdot k_{I2}$), and 1208 ($I_A \cdot k_{I3}$) along with the non-diagonal current matrix M(I) 1202.

Then, as in FIG. 10, the voltage matrix M(V) 1066 outputs V1, V2, and V3 as the calibrated $V_A$ 1016 ($V'_A$ 1074), $V_B$ 1020 ($V'_B$ 1076), and $V_C$ 1024 ($V'_C$ 1078). However, the current matrix 1062 now outputs a virtual current distribution re-configuration correcting the connection errors in the ADC 1002, outputting I1, 12, and 13, respectively, as the calibrated $I_C$ 1026 ($I'_C$ 1210), $I_A$ 1018 ($I'_A$ 1212), and $I_B$ 1022 ($I'_B$ 1214). The instantaneous power P1 1092, P2 1094, and P3 1096 may then be respectively determined based on the instantaneous products of the virtual current distribution re-configuration voltage-current output pairs ($V'_A$, $I'_C$), ($V'_B$, I'A), and ($V'_C$, I'B).

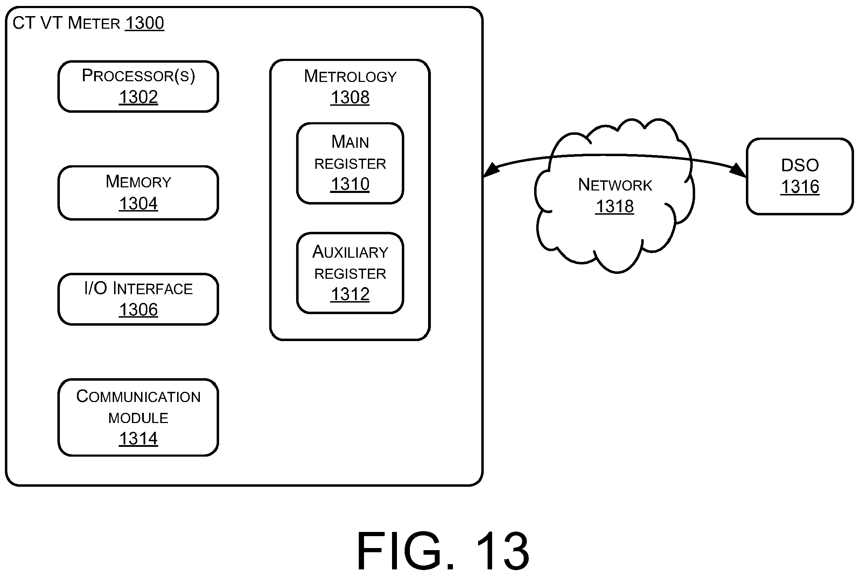

FIG. 13 illustrates an example block diagram of a CT VT meter 1300 capable of generating virtual distribution re-configuration as described above.

The CT VT meter 1300 may comprise one or more processors (processors) 1302 communicatively coupled to memory 1304. The processors 1302 may include a central processing CPUs, graphics processing units (GPUs), both CPUs and GPUs, or other processing units or components known in the art. The processors 1302 may execute computer-executable instructions to perform functions as described above with reference to FIGs. 2-12, such as generating and analyzing Argand diagrams and generating the virtual voltage distribution re-configuration and the virtual current distribution re-configuration, conjunction with the components of the CT VT meter 1300 described below.

Depending on the exact configuration and type of the CT VT meter 1300, the memory 1304 may be volatile, such as RAM, non-volatile, such as ROM, flash memory, miniature hard drive, memory card, and the like, or some combination thereof. The memory 1304 may store the computer-executable instructions that are executable by the processors 1302.

The CT VT meter 1300 may additionally include an input/output (I/O) interface 1306 for receiving data, such as network data packets, and for outputting processed data. The CT VT meter 1300 may also include a metrology module 1308 comprising sensors, front-end analog-to-digital converters (ADCs), and digital filters, and the like, for monitoring and reporting desired metrology parameters such as voltage, current, consumed or generated power, active and reactive power factor, and the like. The metrology module 1208 may further comprise a main register 1310 and an auxiliary register 1312. The main register 1310 may be utilized for monitoring and reporting the metrology parameters as the CT VT meter 1300 is currently connected, and the auxiliary register 1312 may be utilized for generating and reporting revised metrology parameters based on the virtual voltage distribution re-configuration and/or the virtual current distribution re-configuration.

The CT VT meter 1300 may further comprise a communication module 1314 allowing the CT VT meter 1300 to communicate with other device(s), system(s), and/or the DSO 1316 over a network 1318. For example, the CT VT meter 1300 may transmit an alarm when incorrect connections are detected, and may transmit to the DSO the virtual voltage distribution re-configuration and/or the virtual current distribution re-configuration, and the current metrology parameters and the revised metrology parameters. The network 1318 may include the Internet, wired media such as a wired network or direct-wired connections, and wireless media such as acoustic, radio frequency (RF), infrared, cellular networks, and other wireless media.

Some or all operations of the methods described above can be performed by execution of computer-readable instructions stored on a computer-readable storage medium, as defined below. The term "computer-readable instructions" as used in the description and claims, include routines, applications, application modules, program modules, programs, components, data structures, algorithms, and the like. Computer-readable instructions can be implemented on various system configurations, including single-processor or multiprocessor systems, minicomputers, mainframe computers, personal computers, hand-held computing devices, microprocessor-based, programmable consumer electronics, combinations thereof, and the like.

The computer-readable storage media may include volatile memory (such as random-access memory (RAM)) and/or non-volatile memory (such as read-only memory (ROM), flash memory, etc.). The computer-readable storage media may also include additional removable storage and/or non-removable storage including, but not limited to, flash memory, magnetic storage, optical storage, and/or tape storage that may provide non-volatile storage of computer-readable instructions, data structures, program modules, and the like.

A non-transitory computer-readable storage medium is an example of computer-readable media. Computer-readable media includes at least two types of computer-readable media, namely computer-readable storage media and communications media. Computer-readable storage media includes volatile and non-volatile, removable and non-removable media implemented in any process or technology for storage of information such as computer-readable instructions, data structures, program modules, or other data. Computer-readable storage media includes, but is not limited to, phase change memory (PRAM), static random-access memory (SRAM), dynamic random-access memory (DRAM), other types of random-access memory (RAM), read-only memory (ROM), electrically erasable programmable read-only memory (EEPROM), flash memory or other memory technology, compact disk read-only memory (CD-ROM), digital versatile disks (DVD) or other optical storage, magnetic cassettes, magnetic tape, magnetic disk storage or other magnetic storage devices, or any other non-transmission medium that can be used to store information for access by a computing device. In contrast, communication media may embody computer-readable instructions, data structures, program modules, or other data in a modulated data signal, such as a carrier wave, or other transmission mechanism. As defined herein, computer-readable storage media do not include communication media.

The computer-readable instructions stored on one or more computer-readable storage media that may be non-transitory computer-readable storage media, when executed by one or more processors, may perform operations described above with reference to FIGs. 2-13. Generally, computer-readable instructions include routines, programs, objects, components, data structures, and the like that perform particular functions or implement particular abstract data types. The order in which the operations are described is not intended to be construed as a limitation, and any number of the described operations can be combined in any order and/or in parallel to implement the processes.

**CONCLUSION**

Although the subject matter has been described in language specific to structural features and/or methodological acts, it is to be understood that the subject matter defined in the appended claims is not necessarily limited to the specific features or acts described. Rather, the specific features and acts are disclosed as exemplary forms of implementing the claims.

**Claims**

1. A method performed by an electricity meter comprising:

   determining a plurality of voltage vectors monitored at respective voltage terminals of the electricity meter and a voltage vector sequence of the plurality of voltage vectors;
   determining a plurality of current vectors monitored at respective current terminals of the electricity meter and a current vector sequence of the plurality of current vectors;
   determining a phase difference between each voltage vector of the plurality of voltage vectors and a corresponding current vector of the plurality of current vectors;
   determining a quadrant location of each current vector of the plurality of current vectors;
   based at least in part on the quadrant location of each current vector of the plurality of current vectors, calculating a revised power consumption based on at least one of:

      a virtual voltage distribution re-configuration, or
      a virtual current distribution re-configuration.

2. The method of claim 1, wherein determining the phase difference between each voltage vector of the plurality of voltage vectors and the corresponding current vector of the plurality of current vectors comprises:
   determining complementary phase correction parameters for voltage vector pairs, each voltage vector pair comprising a pair of voltage vectors of the plurality of voltage vectors that are adjacent to each other.

3. The method of claim 2, further comprising:
   upon determining that the voltage vector sequence is a negative sequence, generating the virtual voltage distribution re-configuration based upon the current vector sequence, the phase differences, and the quadrant locations.

4. The method of claim 2, further comprising:
   upon determining that the voltage vector sequence is a positive sequence, generating the virtual current distribution re-configuration based upon the current vector sequence, the phase differences, and the quadrant locations.

5.  The method of any of claims 2 to 4, further comprising, prior to determining the voltage vector sequence of the plurality of voltage vectors:

    determining whether a respective amplitude of each of the plurality of voltage vectors is within a predetermined range of a nominal value; and
    at least one of:

        upon determining that the respective amplitude of each of the plurality of voltage vectors is within the predetermined range of the nominal value, determining that a neutral terminal of the electricity meter is correctly connected; or
        upon determining that at least one amplitude of a voltage vector of the plurality of voltage vectors is not within the predetermined range of the nominal value:

            determining that the neutral terminal of the electricity meter is not correctly connected, and generating an alarm.

6.  The method of any of claims 2 to 5, further comprising:
    generating an alarm in response to determining that, at least one of:

        the voltage vector sequence is the negative sequence,
        the current sequence is the negative sequence, or
        at least one determined quadrant location is different from an expected quadrant location.

7.  The method of any of claims 2 to 6, further comprising:
    determining that at least one determined quadrant location is different from an expected quadrant location based on a customer usage of the electricity meter.

8.  The method of any of claims 2 to 7, further comprising:

        calculating an original power consumption based on the plurality of voltage vectors in the determined voltage vector sequence and the plurality of current vectors in the determined current vector sequence;
        calculating a ratio of the revised power consumption to the original power consumption; and
        upon determining that the ratio is greater than a threshold value, generating a notification indicative of an incorrect wiring of at least one of the voltage terminals or the current terminals.

9.  The method of any of claims 2 to 8, wherein generating the virtual voltage distribution re-configuration comprises:
    indicating two or more voltage lines to be connected to voltage terminals that are different from currently connected voltage terminals.

10. The method of any of claims 2 to 9, wherein generating the virtual current distribution re-configuration comprises:
    indicating at least one current line to be re-connected to another current terminal.

11. The method of any of claims 2 to 10, wherein calculating the revised power consumption comprises:
    calculating the revised power consumption on an auxiliary register of the electricity meter.

12. The method of any of claims 2 to 11, further comprising:
    storing at least one of the virtual voltage distribution re-configuration or the virtual current distribution re-configuration in memory of the electricity meter.

13. The method of any of claims 2 to 12, wherein:

        determining the voltage vector sequence of the plurality of voltage vectors based on the respective phase of each voltage vector of the plurality of voltage vectors comprises presenting the plurality of voltage vectors on an Argand diagram, and
        determining the current vector sequence of the plurality of current vectors based on the respective phase of each current vector of the plurality of current vectors comprises presenting the plurality of current vectors on the Argand diagram.

14. An electricity meter comprising:

one or more processors;

memory communicatively coupled to the one or more processors, the memory storing thereon computer executable instructions that, when executed by the one or more processors, cause the one or more processors to perform operations comprising:

determining a plurality of voltage vectors monitored at respective voltage terminals of the electricity meter and a voltage vector sequence of the plurality of voltage vectors;

determining a plurality of current vectors monitored at respective current terminals of the electricity meter and a current vector sequence of the plurality of current vectors;

determining a phase difference between each voltage vector of the plurality of voltage vectors and a corresponding current vector of the plurality of current vectors;

determining complementary phase correction parameters for voltage vector pairs, each voltage vector pair comprising a pair of voltage vectors of the plurality of voltage vectors that are adjacent to each other;

determining a quadrant location of each current vector of the plurality of current vectors;

based at least in part on the quadrant location of each current vector of the plurality of current vectors, calculating a revised power consumption based on at least one of:

a virtual voltage distribution re-configuration, or

a virtual current distribution re-configuration.

15. A computer-readable storage medium storing computer-readable instructions executable by one or more processors that, when executed by the one or more processors, cause the one or more processors to perform operations comprising:

determining a plurality of voltage vectors monitored at respective voltage terminals of an electricity meter and a voltage vector sequence of the plurality of voltage vectors;

determining a plurality of current vectors monitored at respective current terminals of the electricity meter and a current vector sequence of the plurality of current vectors;

determining a phase difference between each voltage vector of the plurality of voltage vectors and a corresponding current vector of the plurality of current vectors;

determining complementary phase correction parameters for voltage vector pairs, each voltage vector pair comprising a pair of voltage vectors of the plurality of voltage vectors that are adjacent to each other;

determining a quadrant location of each current vector of the plurality of current vectors;

based at least in part on the quadrant location of each current vector of the plurality of current vectors, calculating a revised power consumption based on at least one of:

a virtual voltage distribution re-configuration, or

a virtual current distribution re-configuration.

EP 4 134 683 A1

FIG. 1

FIG. 2

| 302 | AMPLITUDE | | PHASE | |
|---|---|---|---|---|
| | V1 = 230V | I1 = 40A | V2/V1 = 120° | I1/V1 = 0° |
| | V2 = 230V | I2 = 20A | V1/V3 = 120° | I2/V2 = 0° |
| | V3 = 230V | I3 = 20A | V3/V2 = 120° | I3/V3 = 0° |

304

306

# FIG. 3

402

| | PHASE | 1 | 2 | 3 |
|---|---|---|---|---|
| VOLTAGE | ANGLE | 0.00° | 240.00° | 120.10° |
| | V*VT RATIO | 230.00 | 230.10 | 229.60 |
| CURRENT | POWER FACTOR | 0.940 | 0.940 | 0.940 |
| | ANGLE I TO V | 20.00° | 19.90° | 19.90° |
| | A*CT RATIO | 148.600 | 149.100 | 148.500 |

404

FIG. 4

502

| | PHASE | 1 | 2 | 3 |
|---|---|---|---|---|
| VOLTAGE | ANGLE | 0.00° | 240.00° | 120.10° |
| | V*VT RATIO | 230.10 | 230.10 | 229.70 |
| CURRENT | POWER FACTOR | -1.000 | 1.000 | 1.000 |
| | ANGLE I TO V | 180.00° | 0.00° | 0.00° |
| | A*CT RATIO | 148.900 | 149.200 | 148.600 |

504

FIG. 5

602

| | PHASE | 1 | 2 | 3 |
|---|---|---|---|---|
| VOLTAGE | ANGLE | 0.00° | 120.00° | 240.00° |
| | V*VT RATIO | 230.10 | 230.10 | 230.10 |
| CURRENT | POWER FACTOR | -0.173 | -0.767 | 0.940 |
| | ANGLE I TO V | -99.90° | 140.10° | 19.90° |
| | A*CT RATIO | 148.100 | 148.400 | 148.800 |

604

I1
99.90°

V2
120.00°

+

V1
0.00°

I2
339.90°

I3
220.10°

V3
240.00°

# FIG. 6

<u>702</u>

| | PHASE | 1 | 2 | 3 |
|---|---|---|---|---|
| VOLTAGE | ANGLE | 0.00° | 240.00° | 120.00° |
| | V*VT RATIO | 230.30 | 229.80 | 230.10 |
| CURRENT | POWER FACTOR | 0.766 | -0.172 | 0.940 |
| | ANGLE I TO V | -40.00° | -99.90° | 19.90° |
| | A*CT RATIO | 148.200 | 148.900 | 148.700 |

<u>704</u>

## FIG. 7

800

```
        ┌─────────────────────────┐
        │           IS            │  NO
        │ NEUTRAL CORRECTLY WIRED? ├──────────────┐
        │          802            │              │
        └────────────┬────────────┘              │
                  YES │                           ▼
        ┌────────────────────────┐      ┌──────────────┐
        │ DETERMINE PHASE ROTATION│      │   TERMINATE  │
        │  OF VOLTAGE VECTORS AND │      │     804      │
        │     CURRENT VECTORS     │      └──────────────┘
        │          806           │
        └────────────┬───────────┘
```

Is NEUTRAL CORRECTLY WIRED? 802

DETERMINE PHASE ROTATION OF VOLTAGE VECTORS AND CURRENT VECTORS 806

VOLTAGE VECTOR SEQUENCE AND CURRENT VECTOR SEQUENCE IDENTICAL? 808

TERMINATE 804

GENERATE VIRTUAL CURRENT DISTRIBUTION RE-CONFIGURATION BASED ON CURRENT VECTOR SEQUENCE, PHASE DIFFERENCES, AND QUADRANT LOCATIONS OF CURRENT VECTORS 810

GENERATE VIRTUAL CURRENT VECTOR SEQUENCE CORRECTING ABNORMAL QUADRANT LOCATION AND PHASE DIFFERENCES BETWEEN VOLTAGE AND CURRENT VECTORS 812

CALCULATE REVISED POWER CONSUMPTION BASED ON AT LEAST ONE OF VIRTUAL VOLTAGE DISTRIBUTION RE-CONFIGURATION OR VIRTUAL CURRENT DISTRIBUTION RE-CONFIGURATION 814

CALCULATE A RATIO OF THE REVISED POWER CONSUMPTION TO THE ORIGINAL POWER CONSUMPTION 816

TRANSMIT NOTIFICATION TO DSO IF RATIO IS GREATER THAN THRESHOLD 818

# FIG. 8

902

| Phase | 1 | 2 | 3 |
|---|---|---|---|
| Voltage | V1 | V2 | V3 |
| Current | I2 | I3 | I1 |

904

ANGLE (V/I) (°)

——— P$_{CORRECT}$   - - - - P$_{INCORRECT}$

906

ANGLE (V/I) (°)

——— Q$_{CORRECT}$   - - - - Q$_{INCORRECT}$

# FIG. 9

FIG. 10

FIG. 11

EP 4 134 683 A1

FIG. 12

FIG. 13

EP 4 134 683 A1

Europäisches
Patentamt

European
Patent Office

Office européen
des brevets

# EUROPEAN SEARCH REPORT

**Application Number**

EP 21 19 0312

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 110 609 165 A (STATE GRID TIANJIN ELECTRIC POWER CO ELECTRIC POWER RES INST ET AL.) 24 December 2019 (2019-12-24) * the whole document * | 1-15 | INV. G01R25/04 G01R25/00 G01R22/06 |
| X | US 2012/084037 A1 (TANAKA RYOHEI [JP]) 5 April 2012 (2012-04-05) * abstract; claims 1-8; figures 1-11 * * paragraph [0016] - paragraph [0029] * * paragraph [0042] - paragraph [0111] * | 1-15 | |
| X | CN 110 763 940 A (LIN XIN) 7 February 2020 (2020-02-07) * the whole document * | 1-15 | |
| X | KR 2010 0096782 A (UNIV ULSAN FOUND FOR IND COOP [KR]) 2 September 2010 (2010-09-02) * abstract; claims 1-18; figures 1-14c * * paragraph [0002] - paragraph [0163] * | 1-15 | |
| X | KR 2009 0093609 A (NPN CO LTD [KR]; UNIV ULSAN FOUND FOR IND COOP [KR]) 2 September 2009 (2009-09-02) * abstract; claims 1-7; figures 1-7b * * paragraph [0007] - paragraph [0078] * | 1-15 | TECHNICAL FIELDS SEARCHED (IPC) G01R |

The present search report has been drawn up for all claims

| Place of search | Date of completion of the search | Examiner |
|---|---|---|
| Munich | 2 February 2022 | Nadal, Rafael |

EPO FORM 1503 03.82 (P04C01)

## ANNEX TO THE EUROPEAN SEARCH REPORT
## ON EUROPEAN PATENT APPLICATION NO.

EP 21 19 0312

This annex lists the patent family members relating to the patent documents cited in the above-mentioned European search report.
The members are as contained in the European Patent Office EDP file on
The European Patent Office is in no way liable for these particulars which are merely given for the purpose of information.

02-02-2022

| Patent document cited in search report | | Publication date | Patent family member(s) | | Publication date |
|---|---|---|---|---|---|
| CN 110609165 | A | 24-12-2019 | NONE | | |
| US 2012084037 | A1 | 05-04-2012 | JP | 5524796 B2 | 18-06-2014 |
| | | | JP | 2012078138 A | 19-04-2012 |
| | | | KR | 20120033978 A | 09-04-2012 |
| | | | US | 2012084037 A1 | 05-04-2012 |
| CN 110763940 | A | 07-02-2020 | NONE | | |
| KR 20100096782 | A | 02-09-2010 | NONE | | |
| KR 20090093609 | A | 02-09-2009 | NONE | | |

For more details about this annex : see Official Journal of the European Patent Office, No. 12/82